# EUROPEAN PATENT APPLICATION

(11) **EP 1 635 401 A1**
(43) Date of publication of application: **15.03.2006**
(21) Application number: 05019376.2
(22) Date of filing: 06.09.2005
(51) Int. Cl.: H01L 31/0304

(54) **Epitaxial wafer and device**

(30) Priority: 13.09.2004 JP 2004265537
(71) Applicant: Sumitomo Electric Industries, Ltd., Osaka-shi, Osaka 541-0041 (JP)
(72) Inventor: Sawada, Shigeru Itami Works of Sumitomo Electric, Itami-shi Hyogo 664-8611 (JP); Iwasaki, Takashi Itami Works of Sumitomo Electric, Itami-shi Hyogo 664-8611 (JP)
(74) Representative: Grünecker, Kinkeldey, Stockmair & Schwanhäusser Anwaltssozietät

(57) **Abstract**

An epitaxial wafer and a device having improved characteristics are obtained. The epitaxial wafer includes a substrate (3), a buffer layer (9) formed on the substrate (3), a light-receiving layer (11) formed on the buffer layer (9), and a window layer (13) The light-receiving layer (11) is constituted of an epitaxial film having its lattice constant larger than that of a material of which the substrate (3) is made. The window layer (13) is formed on the light-receiving layer (11) and constituted of one or a plurality of layers arranged to contact the light-receiving layer (11). A constituent layer of the window layer (13) that is in contact with the light-receiving layer (11) has its lattice constant smaller than the larger one of respective lattice constants of the light-receiving layer (11) and the buffer layer (9). The window layer (13) has a thickness of at least 0.2 µm and at most 2.0 µm.

## Description

### BACKGROUND OF THE INVENTION

### Field of the Invention

The present invention relates to an epitaxial wafer and a device. In particular, the invention relates to a lattice-mismatched compound semiconductor epitaxial wafer and a device manufactured by using the epitaxial wafer.

### Description of the Background Art

An epitaxial wafer including a substrate and an epitaxial layer formed on the substrate and having a lattice constant different from that of the substrate as well as a device manufactured by using the epitaxial wafer have been known (for example see Japanese Patent Laying-Open Nos. 06-188447 and 2003-309281). Japanese Patent Laying-Open No. 06-188447 discloses a photodiode that is a device including, with the purpose of improving device characteristics, a buffer layer formed on a substrate and having multi-level strained superlattice layers inserted thereto, a GaInAs absorber layer formed on the buffer layer and serving as an operating layer and an InAsP window layer formed on the GaInAs absorber layer, having a thickness of at most 0.1 µm and having its lattice constant matching that of the GaInAs absorber layer with a tolerance of -0.5 to 0.5 %. According to Japanese Patent Laying-Open No. 06-188447, the GaInAs absorber layer is formed as an operating layer on the buffer layer to accommodate the lattice mismatch of the GaInAs absorber layer, the thin InAsP window layer is formed to reduce absorption and interference of light in the window layer, and accordingly the photodiode having high spectral sensitivity can be implemented.

Japanese Patent Laying-Open No. 2003-309281 discloses a light-receiving device having an InGaAs light-receiving layer between an InP substrate or InP buffer layer and an InP window layer. Regarding this light-receiving device, the composition of the mixed crystal InGaAs in the light-receiving layer is not constant. Specifically, the proportion of the In content varies in the direction of the thickness of the layer. More specifically, in the InGaAs light-receiving layer serving as an operating layer, with the purpose of improving the lattice match at the interface with the InP substrate or InP buffer layer or the interface with the InP window layer, the proportion of the In content is made lower as approaching these adjacent layers. Consequently, occurrences of interface strain due to a large lattice-constant difference at the interfaces between the light-receiving layer and the adjacent layers respectively can be reduced and accordingly, numerous lattice defects serving to accommodate the lattice strain can be prevented from being incorporated into the light-receiving layer.

The inventor has found through studies that, even if the lattice mismatch with adjacent layers is alleviated to prevent the incorporation of such a lattice defect as dislocation into the operating layer, this approach is not enough to improve the crystallinity of the operating layer. In other words, while the fact that the lattice defects are fewer is surely an important factor in determining whether the crystallinity of the operating layer is excellent or not, the inventor has found that it is also an important factor to prevent mechanical strain that occurs in the operating layer when subjected to annealing for example in the manufacturing process of the device. Improvements in crystallinity of the operating layer by preventing such mechanical strain have not been made. Thus, improvements in characteristics by improvements in crystallinity of the operating layer of the device have been insufficient.

### SUMMARY OF THE INVENTION

An object of the present invention is to provide an epitaxial wafer and a device with improved characteristics.

According to the present invention, an epitaxial wafer includes a substrate, a buffer layer, an operating layer and a window layer. The buffer layer is formed on the substrate. The operating layer is formed on the buffer layer. The operating layer is constituted of an epitaxial film having its lattice constant larger than that of a material of which the substrate is made. The window layer is formed on the operating layer and constituted of one or a plurality of layers arranged to be in contact with the operating layer. A layer that is a constituent layer of the window layer and that is in contact with the operating layer has its lattice constant smaller than the larger one of respective lattice constants of the operating layer and the buffer layer. The window layer has a thickness of at least 0.2 µm and at most 2.0 µm.

Accordingly, in the case where the lattice constant of the buffer layer is larger than the lattice constant of the operating layer, the constituent layer of the window layer that is in contact with the operating layer (hereinafter referred to as contact layer) has its lattice constant at least smaller than the buffer layer. Therefore, in such a case where annealing for example in the manufacturing process of the epitaxial wafer causes the buffer layer, operating layer and contact layer to increase in temperature and thermally expand, the degree of thermal expansion of the contact layer of the window layer can be made smaller than the degree of thermal expansion of the buffer layer. Thus, strain occurring (due to the thermal expansion of the contact layer) at a contact portion of the operating layer with the window layer can be made smaller than strain occurring (due to the thermal expansion of the buffer layer) at a contact portion of the operating layer with the buffer layer. Thus, as compared with the case where the lattice constant of the contact layer is equivalent to or larger than the lattice constant of the buffer layer, the strain of the operating layer can be made smaller while the strain due to the contact layer acts as a force in the direction of canceling the strain from the buffer layer. In this way, the crystallinity of the operating layer can be improved. Consequently, a lattice-mismatched epitaxial wafer can be obtained that has improved characteristics of the operating layer (for example, if the operating layer is a light-receiving layer, the light-receiving sensitivity is improved by noise reduction).

Further, as the thickness of the window layer is defined as indicated above, the force in the direction of canceling the strain from the buffer layer to the operating layer can sufficiently be applied without deterioration in sensitivity of the operating layer. Specifically, if the window layer is smaller than 0.2 µm in thickness, the window layer is too thin so that sufficient strain cannot be applied to the operating layer. If the window layer exceeds 2.0 µm in thickness, the window layer is too thick so that the sensitivity of the operating layer when used as a light-receiving layer for example is deteriorated.

Regarding the above-described epitaxial wafer, the constituent layer of the window layer that is in contact with the operating layer has its lattice constant smaller than the smaller one of respective lattice constants of the operating layer and the buffer layer.

It is supposed here that the buffer layer is larger in lattice constant than the operating layer. Then, the contact layer of the window layer that is in contact with the operating layer has its lattice constant smaller than the lattice constant of the operating layer. Therefore, in the case where annealing for example in the manufacturing process of the epitaxial wafer causes the buffer layer, operating layer and contact layer to increase in temperature and thermally expand, the degree of thermal expansion of the operating layer is smaller than the degree of thermal expansion of the buffer layer and the degree of thermal expansion of the contact layer of the window layer is smaller than the degree of thermal expansion of the operating layer. Thus, the direction of strain occurring (due to the thermal expansion of the buffer layer) at a contact portion of the operating layer with the buffer layer and the direction of strain occurring (due to thermal expansion of the contact layer) at a contact portion of the operating layer with the window layer can be made opposite to each other. Accordingly, in the operating layer, the strain due to the thermal expansion of the buffer layer and the strain due to the thermal expansion of the contact portion act in the directions to cancel respective influences. In this way, deterioration in crystallinity of the operating layer due to the strain can be prevented and consequently operating characteristics of the operating layer can be improved.

Regarding the above-described epitaxial wafer, the operating layer may be constituted of a plurality of layers. The constituent layer of the window layer that is in contact with the operating layer may have its lattice constant smaller than the larger one of the lattice constant of a layer that is a constituent layer of the operating layer and that is in contact with the window layer and the lattice constant of the buffer layer. In this case, as the operating layer is constituted of a plurality of layers, the degree of freedom in designing the epitaxial wafer can be extended.

Regarding the above-described epitaxial wafer, the substrate may be an indium phosphide (InP) substrate, the buffer layer may be made of indium arsenide phosphide (InAs_{X}P_{1-X}), the operating layer may be made of indium gallium arsenide (In_{Y}Ga_{1-Y}As), and the window layer may be made of indium arsenide phosphide (InAs_{Z}P_{1-Z}). In this case, a lattice-mismatched compound semiconductor epitaxial wafer particularly appropriate for producing an infrared light-receiving device receiving radiation with the wavelength range from 1.6 to 2.6 µm can be obtained.

Regarding the above-described epitaxial wafer, the constituent layer of the window layer that is in contact with the operating layer may be different in degree of lattice mismatch from the buffer layer by more than 0 % and at most 1.0 %, which is preferably at least 0.03 % and at most 1.0 %. In this case, improvements in crystallinity of the operating layer can further be ensured. If the difference in degree of lattice mismatch is 0 %, it is difficult to generate, by thermal expansion of the window layer, strain that relieves strain of the operating layer due to thermal expansion of the buffer layer. If the difference in degree of lattice mismatch exceeds 1.0 %, strain of the operating layer due to thermal expansion of the window layer is too large and thus the crystallinity of the operating layer is adversely affected and numerous lattice defects are generated in the operating layer in the end. Consequently, it could occur that the crystallinity of the operating layer deteriorates so that the operating layer does not normally operate. If the difference in degree of lattice mismatch is 0.03 % or higher, strain in the direction of relieving strain due to thermal expansion of the buffer layer can sufficiently be applied from the window layer to the operating layer.

Regarding the above-described epitaxial wafer, the constituent layer of the window layer that is in contact with the operating layer may be different in degree of lattice mismatch from the operating layer by more than 0 % and at most 1.0 %, which is preferably at least 0.03 % and at most 1.0 %.

In this case, improvements in crystallinity of the operating layer can further be ensured. If the difference in degree of lattice mismatch is 0 %, it is difficult to generate, by thermal expansion of the window layer, strain that relieves strain of the operating layer due to thermal expansion of the buffer layer. If the difference in degree of lattice mismatch exceeds 1.0 %, strain of the operating layer due to thermal expansion of the window layer is too large and thus the crystallinity of the operating layer is adversely affected. Consequently, it could occur that the crystallinity of the operating layer deteriorates so that the operating layer does not normally operate. If the difference in degree of lattice mismatch is 0.03 % or higher, strain in the direction of relieving strain due to thermal expansion of the buffer layer can sufficiently be applied from the window layer to the operating layer.

According to the present invention, an epitaxial wafer includes a substrate, a buffer layer, an operating layer and a window layer. The buffer layer is formed on the substrate. The operating layer is formed on the buffer layer and constituted of an epitaxial film having its lattice constant larger than that of a material of which the substrate is made. The window layer is formed on the operating layer and constituted of one or a plurality of layers arranged to be in contact with the operating layer. A layer that is a constituent layer of the window layer and that is in contact with the operating layer and the buffer are made of a material composed of the same constituent elements and, as the content of an impurity element included in the constituent elements is higher, the material has a larger lattice constant. The content of the impurity element of the constituent layer of the window layer that is in contact with the operating layer is lower than that of the impurity element of the buffer layer. The window layer has a thickness of at least 0.2 µm and at most 2.0 µm.

Accordingly, the lattice constant of the constituent layer of the window layer that is in contact with the operating layer (contact layer) is smaller than the lattice constant of the buffer layer. Therefore, in the case where annealing for example in the manufacturing process of the epitaxial wafer causes the buffer layer, operating layer and contact layer to increase in temperature and thermally expand, the degree of thermal expansion of the contact layer of the window layer can be made smaller than the degree of thermal expansion of the buffer layer. Thus, strain occurring (due to the thermal expansion of the contact layer) at a contact portion of the operating layer with the contact layer of the window layer can be made smaller than strain occurring (due to the thermal expansion of the buffer layer) at a contact portion of the operating layer with the buffer layer. Thus, as compared with the case where the content of the impurity element in the contact layer of the window layer is higher than the content of the impurity element in the buffer layer (namely the lattice constant of the contact layer is equivalent to or larger than the lattice constant of the buffer layer), the strain of the operating layer can be made smaller while the strain due to the contact layer acts as a force in the direction of canceling the strain from the buffer layer. In this way; the crystallinity of the operating layer can be improved. Consequently, a lattice-mismatched epitaxial wafer can be obtained that has improved characteristics of the operating layer.

Further, as the thickness of the window layer is defined as indicated above, the force in the direction of canceling the strain from the buffer layer to the operating layer can sufficiently be applied without deterioration in sensitivity of the operating layer. Specifically, if the window layer is smaller than 0.2 µm in thickness, the window layer is too thin so that sufficient strain cannot be applied to the operating layer. If the window layer exceeds 2.0 µm in thickness, the window layer is too thick so that the sensitivity of the operating layer when used as a light-receiving layer for example is deteriorated.

Regarding the above-described epitaxial wafer, the substrate may be an indium phosphide (InP) substrate, the buffer layer may be made of indium arsenide phosphide (InAsₓP₁₋ₓ), the operating layer may be made of indium gallium arsenide (In_{Y}Ga_{1-Y}As), the window layer may be made of indium arsenide phosphide (InAs_{z}P_{1-z}), and the impurity element may be arsenic (As). In this case, a lattice-mismatched compound semiconductor epitaxial wafer particularly appropriate for producing an infrared light-receiving device receiving radiation with the wavelength range from 1.6 to 2.6 µm can be obtained.

According to the present invention, an epitaxial wafer includes a substrate, a buffer layer, an operating layer and a window layer. The buffer layer is formed on the substrate. The operating layer is formed on the buffer layer and constituted of an epitaxial film having its lattice constant larger than that of a material of which the substrate is made. The window layer is formed on the operating layer and constituted of one or a plurality of layers arranged to be in contact with the operating layer. A layer that is a constituent layer of the window layer and that is in contact with the operating layer and the buffer layer are made of a material composed of the same constituent elements and, as the content of an impurity element included in the constituent elements is higher, the material has a smaller lattice constant. The content of the impurity element of the constituent layer of the window layer that is in contact with the operating layer is higher than that of the impurity element of the buffer layer. The window layer has a thickness of at least 0.2 µm and at most 2.0 µm.

Accordingly, the lattice constant of the constituent layer of the window layer that is in contact with the operating layer (contact layer) is smaller than the lattice constant of the buffer layer. Therefore, in the case where annealing for example in the manufacturing process of the epitaxial wafer causes the buffer layer, operating layer and contact layer to increase in temperature and thermally expand, the degree of thermal expansion of the contact layer of the window layer can be made smaller than the degree of thermal expansion of the buffer layer. Thus, strain occurring (due to the thermal expansion of the contact layer) at a contact portion of the operating layer with the contact layer of the window layer can be made smaller than strain occurring (due to the thermal expansion of the buffer layer) at a contact portion of the operating layer with the buffer layer. Thus, as compared with the case where the content of the impurity element in the contact layer of the window layer is lower than the content of the impurity element in the buffer layer (namely the lattice constant of the contact layer is equivalent to or larger than the lattice constant of the buffer layer), the strain of the operating layer can be made smaller while the strain due to the contact layer acts as a force in the direction of canceling the strain from the buffer layer. In this way, the crystallinity of the operating layer can be improved. Consequently, a lattice-mismatched epitaxial wafer can be obtained that has improved characteristics of the operating layer.

Regarding the above-described epitaxial wafer, the substrate may be an indium phosphide (InP) substrate, the buffer layer may be made of indium arsenide phosphide (InAs_{X}P_{1-X}), the operating layer may be made of indium gallium arsenide (In_{Y}Ga_{1-Y}As), the window layer may be made of indium arsenide phosphide (InAs_{Z}P_{1-Z}), and the impurity element may be phosphorus (P). In this case, a lattice-mismatched compound semiconductor epitaxial wafer particularly appropriate for producing an infrared light-receiving device receiving radiation with the wavelength range from 1.6 to 2.6 µm can be obtained.

Regarding the above-described epitaxial wafer, the operating layer may be constituted of a plurality of layers. Thus, the degree of freedom in designing the epitaxial wafer can be extended.

According to the present invention, a device is manufactured by using the epitaxial wafer as discussed above. In this way, the device is produced by using the epitaxial wafer having the operating layer with excellent crystallinity and thus the device is excellent in characteristics while the operating layer has a low noise level.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic perspective view of an epitaxial wafer according to the present invention.
Fig. 2 is a schematic cross-sectional view of a light-receiving device that is manufactured by using the epitaxial wafer shown in Fig. 1.
Figs. 3 to 5 schematically show first to third modifications respectively of the light-receiving device of the present invention shown in Fig. 2.
Fig. 6 shows the results of an SIMS analysis of Sample 1 that is a product of the present invention.
Fig. 7 shows the results of an SIMS analysis of Sample 2 that is a comparative example.
Fig. 8 shows the results of an SIMS analysis of Sample 3 that is a product of the present invention.
Fig. 9 shows the results of an SIMS analysis of Sample 4 that is a comparative example.

### DESCRIPTION OF THE PREFERRED EMBODIMENTS

An embodiment of the present invention is hereinafter described in conjunction with the drawings. In the drawings, like or corresponding parts are denoted by like reference characters and the description thereof will not be repeated.

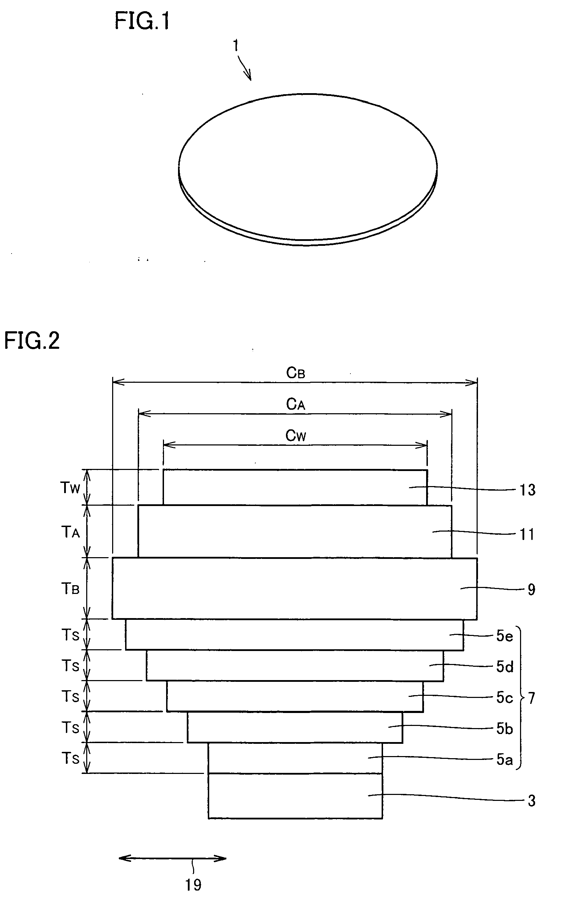

Referring to Figs. 1 and 2, an epitaxial wafer and a light-receiving device of the present invention are hereinafter described.

As shown in Fig. 1, epitaxial wafer 1 according to the present invention is a so-called lattice-mismatched compound semiconductor epitaxial wafer including a substrate and an epitaxial layer that are different in lattice constant from each other. The wafer is structured to have the substrate that is substantially circular or in the shape of a substantially circular plate whose part of its peripheral region is cut off as seen in plan view and that has a predetermined composition, as seen from the structure of the light-receiving device shown in Fig. 2, and a plurality of epitaxial layers formed on the substrate. The light-receiving device shown in Fig. 2 is obtained by dividing epitaxial wafer 1 shown in Fig. 1 into square parts of a predetermined size. In Fig. 2, each of the layers constituting the light-receiving device is drawn in the manner that the width in the lateral direction (direction indicated by arrow 19) corresponds to the magnitude of the lattice constant. The light-receiving device shown in Fig. 2 is an infrared light-receiving device receiving in particular light lays having wavelengths of at least 1.6 µm and at most 2.6 µm (infrared radiation). The infrared light-receiving device includes a substrate 3, a step layer 7 comprised of a plurality of layers with gradually increasing lattice constant, a buffer layer 9 formed on step layer 7, a light-receiving layer 11 formed on buffer layer 9, and a window layer 13 formed on light-receiving layer 11.

More specifically, substrate 3 is a substrate for example made of indium phosphide (hereinafter InP). On this substrate 3, a layer 5a having a substantially identical lattice constant as that of substrate 3 and a plurality of layers 5b-5e gradually increasing in lattice constant are formed. These layers 5a-5e constitute step layer 7. Each of layers 5a-5e of step layer 7 may be made of indium arsenide phosphide (InAs_{X}P_{1-X}: also referred to as InAsP). Layers 5a-5e each may have thickness Ts for example of 0.5 µm. Although the number of layers 5a-5e in step layer 7 may be five as shown, six or more layers, for example, seven or more layers may be formed. The number of layers 5a-5e may alternatively be four or less. For example, the number of layers of step layer 7 may be at least three and at most ten.

On the uppermost layer 5e of step layer 7, buffer layer 9 is formed. Here, buffer layer 9 refers to a layer located on step layer 7 and contacting the light-receiving layer that serves as an operating layer. Buffer layer 9 may be made for example of indium arsenide phosphide (InAsP) as that of step layer 7. As seen from Fig. 2, buffer layer 9 has lattice constant C_{B} larger than the lattice constant of the uppermost layer 5e of step layer 7. Buffer layer 9 may have thickness T_{B} for example of at least 2 µm and at most 3 µm.

Then, on buffer layer 9, light-receiving layer 11 serving as an operating layer is formed. Light-receiving layer 11 is, as seen from Fig. 2, constituted of an epitaxial film having lattice constant C_{A} larger than the lattice constant of a material of which substrate 3 is made. Light-receiving layer 11 may be made for example of indium gallium arsenide (In_{Y}Ga_{1-Y}As: also referred to as InGaAs). Light-receiving layer 11 may have thickness T_{A} for example of at least 2 µm and at most 4 µm. Light-receiving layer 11 has lattice constant C_{A} smaller than lattice constant C_{B} of buffer layer 9. On this light-receiving layer 11, window layer 13 contacting light-receiving layer 11 is formed. Window layer 13 may be made for example of indium arsenide phosphide (InAsP). Window layer 13 may have thickness T_{W} for example of at least 0.2 µm and at most 2 µm that is more preferably at least 0.3 µm and at most 1.5 µm. Lattice constant C_{W} of window layer 13 is set smaller than the larger one of lattice constant C_{A} of light-receiving layer 11 and lattice constant C_{B} of buffer layer 9 (in Fig. 2, smaller than lattice constant C_{A} of light-receiving layer 11 that is the smaller one of lattice constant C_{A} of light-receiving layer 11 and lattice constant C_{B} of buffer layer 9).

The light-receiving device structured as described above can improve the crystallinity of light-receiving layer 11 as compared with conventional products. For example, in terms of PL (Photo-Luminescence) intensity that indicates the quality of the crystallinity of light-receiving layer 11, the PL intensity of light-receiving layer 11 of the epitaxial wafer of the present invention can be improved as compared with conventional products. Consequently, the light-receiving device with further excellent characteristics can be obtained.

Specifically, as shown in Fig. 2, in the case where buffer layer 9 has lattice constant C_{B} larger than lattice constant C_{A} of light-receiving layer 11, a contact layer that is in window layer 13 and that is in contact with light-receiving layer 11 (in the case shown in Fig. 2, window layer 13 has a single-layer structure and thus the contact layer is window layer 13 itself) has lattice constant C_{W} smaller than lattice constant C_{A} of light-receiving layer 11. Therefore, if annealing for example in the manufacturing process of epitaxial wafer 1 causes buffer layer 9, light-receiving layer 11 and window layer 13 to increase in temperature and thermally expand, the degree of the thermal expansion of light-receiving layer 11 is smaller than the degree of the thermal expansion of buffer layer 9 and the degree of the thermal expansion of window layer 13 is smaller than the degree of the thermal expansion of light-receiving layer 11. Therefore, the direction of strain occurring (due to thermal expansion of buffer layer 9) at a contact portion of light-receiving layer 11 that contacts buffer layer 9 (the contact portion is a bottom region of light-receiving layer 11) and the direction of strain occurring (due to thermal expansion of window layer 13) at a contact portion of light-receiving layer 11 that contacts window layer 13 (the contact portion is a top region of light-receiving layer 11) can be made opposite to each other. Accordingly, in light-receiving layer 11, the strain due to the thermal expansion of buffer layer 9 and the strain due to the thermal expansion of window layer 13 act in respective directions to cancel respective influences each other. Consequently, degradation of the crystallinity of light-receiving layer 11 due to such strain can be prevented. In this way, light-receiving layer 11 can have reduced noise level and improved light-receiving sensitivity.

Further, thickness Tw of window layer 13 can be defined as indicated above to apply sufficient force in the direction of canceling the strain exerted from buffer layer 9 to light-receiving layer 11 without lowering the sensitivity of light-receiving layer 11. Specifically, if window layer 13 has a thickness of less than 0.2 µm, window layer 13 is too thin so that sufficient strain cannot be applied to light-receiving layer 11. If window layer 13 has thickness T_{W} larger than 2.0 µm, window layer 13 is too thick so that the sensitivity of light-receiving layer 11 is lowered. Further, if window layer 13 has thickness Tw of at least 0.3 µm and at most 1.5 µm, the effect of canceling strain from buffer layer 9 and the effect of preventing deterioration in sensitivity of light-receiving layer 11 can be balanced while these effects are still kept at higher level. Furthermore, one of the reasons why the lower limit of thickness T_{W} of window layer 13 is set at 0.3 µm is that, when an electrode is provided on the window layer, window layer 13 has to have the thickness of approximately 0.3 µm for preventing direct contact between the electrode and light-receiving layer 11.

Regarding epitaxial wafer 1, between a layer that is in window layer 13 and that is in contact with light-receiving layer 11 (window layer 13 itself in Fig. 2) and light-receiving layer 11, there is a difference in degree of lattice mismatch and the difference is larger than 0 % and at most 1.0 %. Preferably the difference in degree of lattice mismatch is at least 0.03 % and at most 1.0 %. Accordingly, the improvement of the crystallinity of light-receiving layer 11 can further be ensured.

Lattice constant C_{W} of window layer 13 can be set smaller than lattice constant C_{B} of buffer layer 9 or lattice constant C_{A} of light-receiving layer 11 as discussed above in such a system as shown in Fig. 2 in the following way. In the light-receiving device shown in Fig. 2, the layer that is a constituent layer of window layer 13 and that is in contact with light-receiving layer 11 (window layer 13 itself in Fig. 2) and buffer layer 9 are made of the material of the same constituent elements (indium (In), arsenic (As), phosphorus (P)). Regarding arsenic that is an impurity element included in the constituent elements, as the content of this impurity element (arsenic) increases, respective lattice constants of the materials constituting buffer layer 9 and light-receiving layer 11 increase. Further, the content of the impurity element (arsenic) in the layer that is a constituent layer of window layer 13 and that is in contact with light-receiving layer 11 (window layer 13 itself in Fig. 2) is lower than the content of the impurity element (arsenic) in buffer layer 9.

It is supposed here that the aforementioned impurity element included in the constituent elements is phosphorus (P). As the content of the impurity element, namely phosphorus, is higher, respective lattice constants of the materials constituting buffer layer 9 and window layer 13 are smaller. The content of phosphorus that is an impurity element in a layer that is a constituent layer of window layer 13 and that is in contact with light-receiving layer 11 (window layer 13 in Fig. 2) is set higher than the content of phosphorus as an impurity element in buffer layer 9.

As described above, the content of phosphorus or arsenic as an impurity element in window layer 13 and buffer layer 9 each can be set to make lattice constant C_{W} of window layer 13 smaller than lattice constant C_{B} of buffer layer 9.

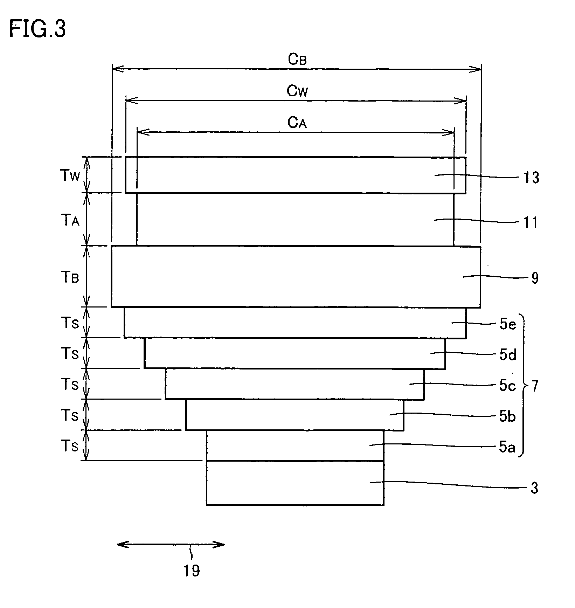

Referring to Fig. 3, a first modification of the light-receiving device of the present invention is described.

The light-receiving device shown in Fig. 3 is basically identical in structure to the light-receiving device shown in Fig. 2, except for the relation in magnitude between lattice constants C_{B}, C_{A} of buffer layer 9 and light-receiving layer 11 and lattice constant Cw of window layer 13. Specifically, regarding the light-receiving device shown in Fig. 3, window layer 13 having lattice constant C_{W} larger than lattice constant C_{A} of light-receiving layer 11 and smaller than lattice constant C_{B} of buffer layer 9 is formed on light-receiving layer 11. In this case as well, the effects similar to those of the light-receiving device shown in Fig. 2 can be achieved. Specifically, lattice constant C_{W} of window layer 13 is smaller than lattice constant C_{B} of buffer layer 9. Therefore, in an annealing process for example of the manufacturing process of epitaxial wafer 1 in which the temperature of buffer layer 9, light-receiving layer 11 and window layer 13 increase and accordingly thermally expand, the degree of thermal expansion of window layer 13 can be made smaller than the degree of thermal expansion of buffer layer 9. Accordingly, strain occurring at a contact portion of light-receiving layer 11 with window layer 13 can be made smaller than strain occurring at a contact portion of light-receiving layer 11 with buffer layer 9. Thus, as compared with the case in which the lattice constant of window layer 13 is equivalent to or larger than the lattice constant of buffer layer 9, the strain of light-receiving layer 11 can be made smaller while strain due to window layer 13 acts as a force canceling strain from buffer layer 9. In this way, the crystallinity of light-receiving layer 11 can be improved.

Further, regarding the light-receiving device shown in Fig. 3 and epitaxial wafer 1 from which the light-receiving device is formed, the difference in degree of lattice mismatch between a layer that is a constituent layer of window layer 13 and that is in contact with light-receiving layer 11 (window layer 13 itself in Fig. 3) and buffer layer 9 is larger than 0 % and at most 1.0 %. Preferably, the difference in degree of lattice mismatch is at least 0.03 % and at most 1.0 %. In this case, improvements of the crystallinity of light-receiving layer 11 can further be ensured. If the difference in degree of lattice mismatch is 0 %, it would be difficult to generate such strain, by thermal expansion of window layer 13, as the one that relieves strain of light-receiving layer 11 due to thermal expansion of buffer layer 9. If the difference in degree of lattice mismatch exceeds 1.0 %, the strain of light-receiving layer 11 due to thermal expansion of window layer 13 is too large and thus adversely affects the crystallinity of light-receiving layer 11. Eventually, numerous lattice defects are generated in light-receiving layer 11. If the difference in degree of lattice mismatch is 0. 03 % or higher, sufficient strain in the direction of relieving the strain due to thermal expansion of buffer layer 9 can be applied to light-receiving layer 11 from window layer 13.

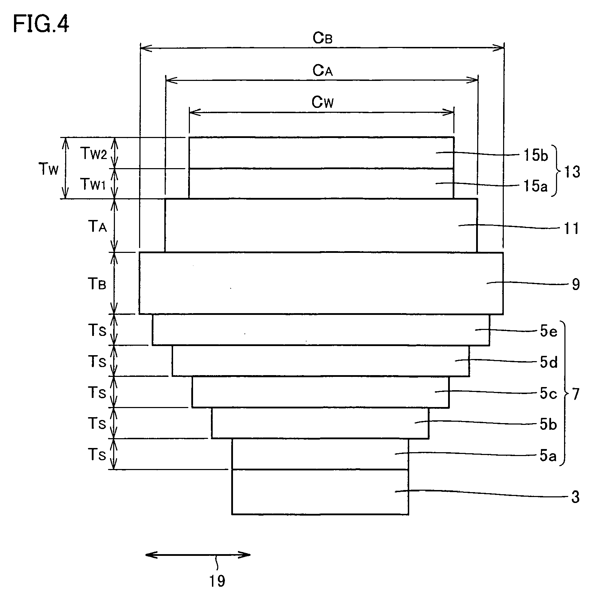

Referring to Fig. 4, a second modification of the light-receiving device of the present invention is described.

As shown in Fig. 4, the light-receiving device is basically identical in structure to the light-receiving device shown in Fig. 2 except that window layer 13 is comprised of two layers that are layers 15a, 15b. Layer 15a has thickness T_{W1} and layer 15b has thickness T_{W2}. As the lattice constant of window layer 13, lattice constant Cw of layer 15a that is in contact with the surface of light-receiving layer 11 is used. Lattice constant C_{W} of this layer 15a is smaller than lattice constant C_{B} of buffer layer 9 and lattice constant C_{A} of light-receiving layer 11, as the light-receiving layer shown in Fig. 2. In this case, the effects of the light-receiving device similar to those of the light-receiving device shown in Fig. 2 can be achieved.

Regarding the light-receiving device shown in Fig. 4, although the constituent layers of window layer 13 are two layers 15a, 15b, the number of layers constituting window layer 13 may be three or more. In this case as well, preferably the lattice constant of window layer 13 is the lattice constant of window layer 15a contacting light-receiving layer 11.

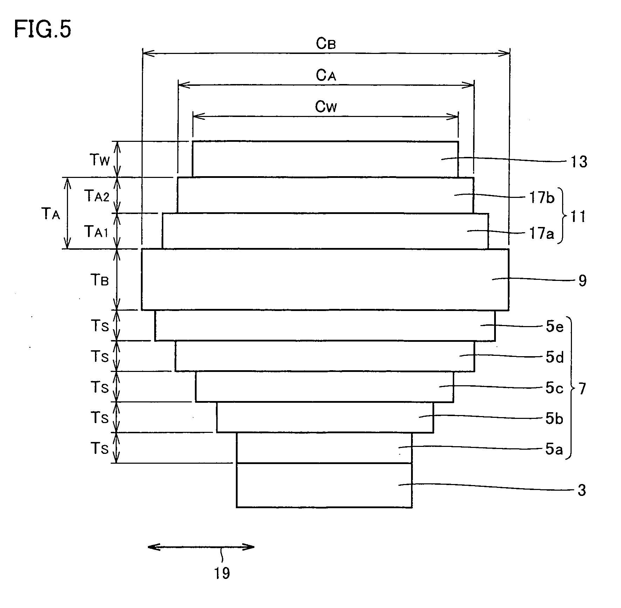

Referring to Fig. 5, a third modification of the light-receiving device of the present invention is described.

The light-receiving device shown in Fig. 5 is basically identical in structure to the light-receiving device shown in Fig. 4 except that light-receiving layer 11 is comprised of two layers that are layers 17a, 17b. Layer 17a has thickness T_{A1} and layer 17b has thickness T_{A2}. As the lattice constant of light-receiving layer 11, the lattice constant of layer 17b that is the uppermost layer of light-receiving layer 11 and that is in contact with window layer 13 is used. The light-receiving device structured in this manner can also achieve similar effects to those of the light-receiving device shown in Fig. 2. Moreover, regarding the structure of light-receiving layer 11, since the composition and thickness of layers 17a, 17b may be designed to vary, the degree of freedom in designing the device can be extended.

For the above-discussed epitaxial wafer and device, as a material to be used for the substrate, GaAs for example may be used instead of InP. As a material for step layer 7 and buffer layer 9, InAlAs, InGaAsP for example may also be used. As a material for light-receiving layer 11, InGaAsP for example may also be used. As a material for window layer 13, InGaAsP, InA1As for example may also be used.

### Example 1

In order to confirm the effects of the present invention, samples as detailed below were prepared and, for each sample, an SIMS (Secondary Ion Mass Spectroscopy) analysis of a cross section was conducted and PL (Photo-Luminescence) intensity was measured. Details are as follows.

The inventor prepared, as samples having a light-receiving sensitivity to 2.2 µm radiation, Sample 1 corresponding to a product of the present invention and Sample 2 corresponding to a comparative example. Specifically, a light-receiving device was prepared that was structured as shown in Fig. 2 to have an InP substrate as substrate 3 on which formed a seven-level InAsP layer as step layer 7. The constituent layers of the InAsP layer each had a thickness of 0.75 µm. The constituent InAsP layers had respective contents of As and P that are varied so that the lattice constant is larger as further from the InP and closer to the higher level in the InAsP layer. As buffer layer 9, an InAsP layer was formed. Buffer layer 9 had a thickness of 2.7 µm. As light-receiving layer 11, an InGaAs layer was formed. Light-receiving layer 11 had a thickness of 3.4 µm. Further, as window layer 13, an InAsP layer was formed. Window layer 13 had a thickness of 1.2 µm. The composition of each of the InP substrate, light-receiving layer 11 and layers therebetween of Sample 1 was the same as that of Sample 2. Sample 1 and Sample 2 were different in composition of window layer 13 (specifically respective contents of phosphorus (P) and arsenic (As)). Specifically, in Sample 1 that is a product of the present invention, the content of arsenic (As) in window layer 13 is lower than the content of arsenic (As) in buffer layer 9. Accordingly, as described hereinlater, lattice constant Cw of window layer 13 of Sample 1 is smaller than lattice constant C_{B} of buffer layer 9 (and than lattice constant C_{A} of light-receiving layer 11 as seen from Fig. 2). In contrast, in Sample 2 that is a comparative example, the content of arsenic (As) in window layer 13 is higher than the content of arsenic (As) in buffer layer 9 as hereinlater described. Accordingly, lattice constant C_{W} of window layer 13 of sample 2 is larger than lattice constant C_{B} of buffer layer 9 (and than lattice constant C_{A} of light-receiving layer 11). It is noted that above-described samples can be produced through usual epitaxial growth.

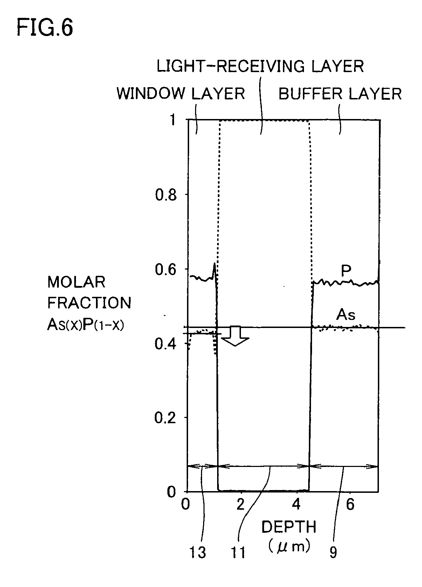

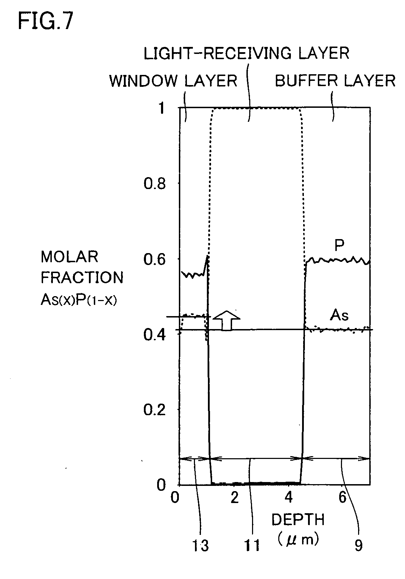

Above-described Sample 1 and Sample 2 were SIMS analyzed. The results are shown in Figs. 6 and 7. As seen from Figs. 6 and 7, regarding Sample 1 that is a product of the present invention, the molar fraction of arsenic (As) in window layer 13 is lower than the molar fraction of arsenic (As) in buffer layer 9. Further, the molar fraction of phosphorus (P) in window layer 13 is higher than the molar fraction of phosphorus (P) in buffer layer 9. In contrast, regarding Sample 2 as a comparative example, the molar fraction of As in window layer 13 is higher than the molar fraction of As in buffer layer 9. Further, the molar fraction ofP in window layer 13 is lower than the molar fraction of P in buffer layer 9. Here, regarding InAsP constituting the window layer and the buffer layer each, there is a tendency that as the molar fraction of As is higher (the molar fraction of P is lower), the lattice constant of InAsP is larger. In other words, regarding the product of the present invention, since the molar fraction of As in window layer 13 is lower than the molar fraction of As in buffer layer 9 (the molar fraction of P in window layer 13 is higher than the molar fraction of P in buffer layer 9), lattice constant Cw of window layer 13 is smaller than lattice constant C_{B} of buffer layer 9. In contrast, as seen from Fig. 7, in Sample 2 as a comparative example, the molar fraction of As in the window layer 13 is higher than the molar fraction of As in buffer layer 9 (the molar fraction of P in window layer 13 is lower than the molar fraction of P in buffer layer 9) and accordingly the lattice constant of window layer 13 is larger than that of buffer layer 9.

For Samples 1 and 2, the PL intensity was measured. Together with the results of the SIMS analysis discussed above, the results of the measurement of the PL intensity are shown in Table 1.

**Table 1**

| | molar fraction of As in InAsP of buffer layer | molar fraction of As InAsP or window layer | composition difference in terms of As between window layer and buffer layer | degree of lattice of mismatch | PL intensity of InGaAs layer (light-receiving layer) |
|---|---|---|---|---|---|
| Sample 1 | 0.445 | 0.432 | -0.013 | -0.041% | 165,306.2 |
| Sample 2 | 0.410 | 0.441 | +0.031 | +0.099% | 0 (below detection limit (10,000)) |

As seen from Table 1, for Sample 2 as a comparative example, the PL intensity cannot be measured (since it is below the measurement limit). In contrast, for Sample 1 as a product of the present invention, a sufficiently high intensity is achieved. It is noted here that the PL intensity reflects the crystallinity of a light-emitting portion (light-receiving layer 11) and any portion having higher crystallinity has a higher PL intensity. In other words, in Sample 1 that is a product of the present invention, the crystallinity of the InGaAs layer constituting light-receiving layer 11 is superior to that of the InGaAs layer constituting the light-receiving layer of Sample 2 as a comparative example. It is thus shown that Sample 1 as a product of the present invention can be used to obtain a light-receiving device with more excellent characteristics.

### Example 2

As Example 1, the inventor prepared two samples (Sample 3 and Sample 4) as light-receiving devices having a light-receiving sensitivity to 2.6 µm radiation. Sample 3 corresponds to a product of the present invention and Sample 4 corresponds to a comparative example. Specifically, Sample 3 and Sample 4 are basically similar in structure to above-described Sample 1 and Sample 2 of Example 1. More specifically, as shown in Fig. 2, on an InP substrate as substrate 3, an eleven-level InAsP layer was formed as step layer 7. The constituent layers of the InAsP layer each had a thickness of 0.5 µm. The constituent InAsP layers had respective contents of As and P that are varied so that the lattice constant is larger as further from the InP and closer to the higher level in the InAsP layer. As buffer layer 9, an InAsP layer was formed. Buffer layer 9 had a thickness of 2.8 µm. As light-receiving layer 11, an InGaAs layer was formed. Light-receiving layer 11 had a thickness of 3.3 µm. Further, as window layer 13, an InAsP layer was formed. Window layer 13 had a thickness of 1.0 µm. The composition of each of the InP substrate, light-receiving layer 11 and layers therebetween of Sample 3 was the same as that of Sample 4. A difference therebetween was the composition of window layer 13 (specifically the contents of phosphorus (P) and arsenic (As)). As for Sample 3 that is a product of the present invention, the content of arsenic (As) in window layer 13 is lower than the content of arsenic (As) in buffer layer 9 (the content of phosphorus (P) in window layer 13 is higher than the content of phosphorus (P) in buffer layer 9) as described below. Accordingly, lattice constant Cw of window layer 13 of Sample 3 is smaller than lattice constant C_{B} of buffer layer 9 (and than lattice constant C_{A} of light-receiving layer 11 as seen from Fig. 2). In contrast, as for Sample 4 as a comparative example, the content of arsenic (As) in window layer 13 is higher than the content of arsenic (As) in buffer layer 9 (the content of phosphorus (P) in window layer 13 is lower than the content of phosphorus (P) in buffer layer 9) as hereinlater described. Accordingly, lattice constant C_{W} of window layer 13 of Sample 4 is larger than lattice constant C_{B} of buffer layer 9 (and than lattice constant C_{A} of light-receiving layer 11).

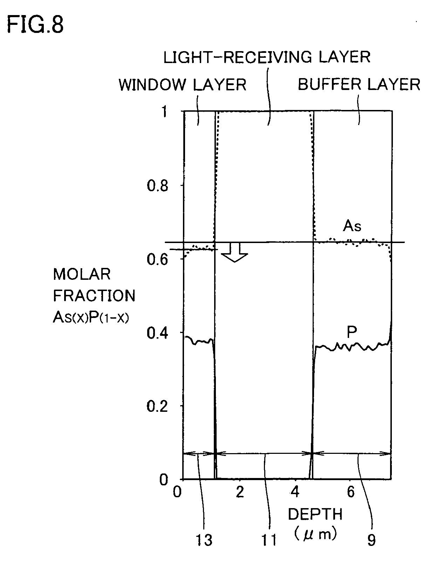

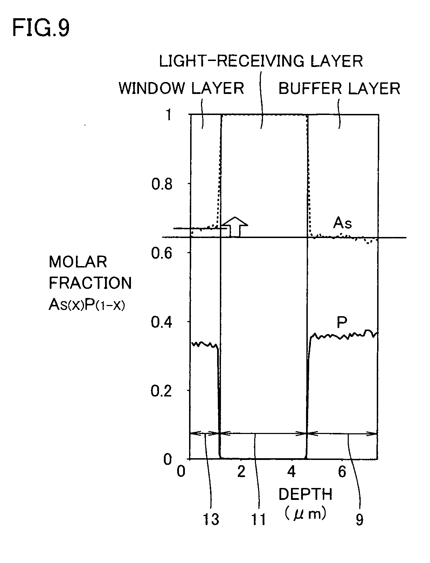

As Example 1, for above-described Sample 3 and Sample 4, an SIMS analysis was conducted and the PL intensity was measured. As seen from Figs. 8 and 9, regarding Sample 3 that is a product of the present invention, the molar fraction of As in window layer 13 is lower than the molar fraction of As in buffer layer 9, like Sample 1 shown in Fig 6. In contrast, regarding Sample 4 as a comparative example, the molar fraction of As in window layer 13 is higher (larger) than the molar fraction of As in buffer layer 9. Accordingly, as Example 1 discussed above, regarding Sample 3 as a product of the present invention, the lattice constant of window layer 13 is smaller than the lattice constant of buffer layer 9 while regarding Sample 4 as a comparative example, the lattice constant of window layer 13 is larger than the lattice constant of buffer layer 9.

As Example 1, for light-receiving layer 11 of Samples 3 and 4 each, the PL intensity was measured. Together with the results of the SIMS analysis mentioned above, the results of the measurement of the PL intensity are shown in Table 2.

**Table 2**

| | molar fraction of As in InAsP of buffer layer | molar fraction of As in InAsP of window layer | composition difference in difference in terms of As between window layer and buffer layer | degree of lattice mismatch mismatch | PL intensity of InGaAs layer (light-receiving layer) |
|---|---|---|---|---|---|
| Sample 3 | 0.651 | 0.628 | -0.023 | -0.073% | 211,913 |
| Sample 4 | 0.651 | 0.673 | +0.022 | +0.069% | 25,943 |

As seen from Table 2, the PL intensity of Sample 3 is at least eight times higher than the PL intensity of Sample 4. It is accordingly seen that the crystallinity of light-receiving layer 11 of Sample 3 as a product of the present invention is superior to the crystallinity of light-receiving layer 11 of Sample 4 as a comparative example. Thus, it is seen that the light-receiving device of Sample 3 as a product of the present invention is superior in characteristics to the light-receiving device of Sample 4 as a comparative example.

Although the present invention has been described and illustrated in detail, it is clearly understood that the same is by way of illustration and example only and is not to be taken by way of limitation, the spirit and scope of the present invention being limited only by the terms of the appended claims.

## Claims

1. An epitaxial wafer comprising:
a substrate (3);
a buffer layer (9) formed on said substrate (3);
an operating layer (11) formed on said buffer layer (9) and constituted of an epitaxial film having its lattice constant larger than that of a material of which said substrate (3) is made; and
a window layer (13) formed on said operating layer (11) and constituted of one or a plurality of layers arranged to be in contact with said operating layer (11), wherein
a layer that is a constituent layer of said window layer (13) and that is in contact with said operating layer (11) has its lattice constant smaller than the larger one of respective lattice constants of said operating layer (11) and said buffer layer (9), and
said window layer (13) has a thickness of at least 0.2 µm and at most 2.0 µm.

2. The epitaxial wafer according to claim 1, wherein
said constituent layer of said window layer (13) that is in contact with said operating layer (11) has its lattice constant smaller than the smaller one of respective lattice constants of said operating layer (11) and said buffer layer (9).

3. The epitaxial wafer according to claim 1, wherein
said operating layer (11) is constituted of a plurality of layers (17a, 17b),
said constituent layer of said window layer (13) that is in contact with said operating layer (11) has its lattice constant smaller than the larger one of the lattice constant of a layer that is a constituent layer (17b) of said operating layer (11) and that is in contact with said window layer (13) and the lattice constant of said buffer layer (9).

4. The epitaxial wafer according to claim 1, wherein
said substrate (3) is an indium phosphide substrate,
said buffer layer (9) is made of indium arsenide phosphide,
said operating layer (11) is made of indium gallium arsenide, and
said window layer (13) is made of indium arsenide phosphide.

5. The epitaxial wafer according to claim 1, wherein
said constituent layer of said window layer (13) that is in contact with said operating layer (11) is different in degree of lattice mismatch from said buffer layer (9) by more than 0 % and at most 1.0%.

6. The epitaxial wafer according to claim 1, wherein
said constituent layer of said window layer (13) that is in contact with said operating layer (11) is different in degree of lattice mismatch from said operating layer (11) by more than 0 % and at most 1.0%.

7. An epitaxial wafer comprising:
a substrate (3);
a buffer layer (9) formed on said substrate (3);
an operating layer (11) formed on said buffer layer (9) and constituted of an epitaxial film having its lattice constant larger than that of a material of which said substrate (3) is made; and
a window layer (13) formed on said operating layer (11) and constituted of one or a plurality of layers arranged to be in contact with said operating layer (11), wherein
a layer that is a constituent layer of said window layer (13) and that is in contact with said operating layer (11) and said buffer layer (9) are made of a material composed of the same constituent elements and, as the content of an impurity element included in said constituent elements is higher, said material has a larger lattice constant,
the content of said impurity element of said constituent layer of said window layer (13) that is in contact with said operating layer (11) is lower than that of said impurity element of said buffer layer (9), and
said window layer (13) has a thickness of at least 0.2 µm and at most 2.0 µm.

8. The epitaxial wafer according to claim 7, wherein
said substrate (3) is an indium phosphide substrate,
said buffer layer (9) is made of indium arsenide phosphide,
said operating layer (11) is made of indium gallium arsenide,
said window layer (13) is made of indium arsenide phosphide, and
said impurity element is arsenic.

9. The epitaxial wafer according to claim 7, wherein
said operating layer (11) is constituted of a plurality of layers (17a, 17b).

10. An epitaxial wafer comprising:
a substrate (3);
a buffer layer (9) formed on said substrate (3);
an operating layer (11) formed on said buffer layer (9) and constituted of an epitaxial film having its lattice constant larger than that of a material of which said substrate (3) is made; and
a window layer (13) formed on said operating layer (11) and constituted of one or a plurality of layers arranged to be in contact with said operating layer (11), wherein
a layer that is a constituent layer of said window layer (13) and that is in contact with said operating layer (11) and said buffer layer (9) are made of a material composed of the same constituent elements and, as the content of an impurity element included in said constituent elements is higher, said material has a smaller lattice constant,
the content of said impurity element of said constituent layer of said window layer (13) that is in contact with said operating layer (11) is higher than that of said impurity element of said buffer layer (9), and
said window layer (13) has a thickness of at least 0.2 µm and at most 2.0 µm.

11. The epitaxial wafer according to claim 10, wherein
said substrate (3) is an indium phosphide substrate,
said buffer layer (9) is made of indium arsenide phosphide,
said operating layer (11) is made of indium gallium arsenide,
said window layer (13) is made of indium arsenide phosphide, and
said impurity element is phosphorus.

12. The epitaxial wafer according to claim 10, wherein
said operating layer (11) is constituted of a plurality of layers (17a, 17b).

13. A device manufactured by using the epitaxial wafer as recited in claim 1.
